# EUROPÄISCHE PATENTSCHRIFT

(11) **EP 2 789 219 B1**
(45) Veröffentlichungstag und Bekanntmachung des Hinweises auf die Patenterteilung: **08.03.2017**
(21) Anmeldenummer: 12805986.2
(22) Anmeldetag: 04.12.2012
(51) Int. Cl.: H05K 7/14, H05K 5/00

(54) **ELEKTRONIKMODUL**
ELECTRONICS MODULE
MODULE ELECTRONIQUE

(30) Priorität: 06.12.2011 DE 102011056082
(43) Veröffentlichungstag der Anmeldung: 15.10.2014
(73) Patentinhaber: Hella KGaA Hueck & Co, 59552 Lippstadt (DE)
(72) Erfinder: RÜTHER, Georg, 33165 Lichtenau (DE); KETTELGERDES, Hubert, 33129 Delbrück (DE)
(86) Internationale Anmeldenummer: PCT/EP2012/074325
(87) Internationale Veröffentlichungsnummer: WO 2013/083549

(56) Entgegenhaltungen:
- EP-A1- 1 130 879
- DE-A1- 3 243 867
- DE-A1-102009 058 181
- DE-U1- 9 201 258

## Beschreibung

Die vorliegende Erfindung betrifft ein Elektronikmodul sowie eine Verfahren für die Montage eines Elektronikmoduls.

Elektronikmodule sowie entsprechende Montageverfahren für Elektronikmodule sind grundsätzlich bekannt. Dabei weisen die Elektronikmodule häufig eine Leiterplatte auf, die im Inneren eines Gehäuses angeordnet werden soll. Solche Leiterplatten können eine Vielzahl von Funktionen erfüllen und insbesondere als Steuer- oder Regelvorrichtungen zum Einsatz kommen. Dabei sind auf den Leiterplatten elektronische Bauteile, wie Widerstände, Transistoren, CPUs oder Ähnliches angeordnet. Um eine Kontaktierung der elektronischen Bauteile auf der Leiterplatte zu ermöglichen ist es bekannt, die Leiterplatte über ein Kabel mit einem Steckkontakt zu verbinden. Dieser Steckkontakt wurde in das Gehäuse eingelassen und konnte dort zum Verbinden des Elektronikmoduls mit weiteren Komponenten, zum Beispiel innerhalb eines Fahrzeuges, verwendet werden. Dabei wurde ein entsprechender Gegenstecker in den Steckkontakt eingesteckt.

Bei neueren Elektronikmodulen wurde versucht die geometrischen Abmessungen des gesamten Elektronikmoduls, insbesondere des Gehäuses, noch weiter zu reduzieren, um Platz zu sparen. Dabei wurde es notwendig, dass zum Beispiel der Steckkontakt direkt als Teil der Leiterplatte ausgebildet wurde. Dies führt dazu, dass die Leiterplatte nunmehr nicht nur die Lagerkräfte der Leiterplatte aufnehmen muss, sondern darüber hinaus auch Kräfte, die beim An- und Abstecken mit einem entsprechenden Gegenstecker am Steckkontakt auftreten.

Bei bekannten Elektronikmodulen wurde die Leiterplatte in besonders einfacherer Weise innerhalb des Gehäuses angeordnet. So war es beispielsweise möglich, dass einfache Kunststoffdome zur Lagerung der Leiterplatte vorgesehen wurden. Auch ist es bekannt, dass diese Kunststoffdome nach dem Aufsetzen und Durchgreifen durch Öffnungen in der Leiterplatte überbügelt worden sind, so dass ein Abschmelzen der Kunststoffdome zu pilzförmigen Köpfen führte, die eine feste Lagerung der Kunststoffplatte ermöglichten. Auch die Verschraubung bzw. das Vernieten der Leiterplatte war bekannt. In beiden Fällen handelt es sich jedoch um relativ aufwendige Verfahren, die insbesondere hinsichtlich des prozessualen Aufwandes, der Qualität der Verbindung und der möglichen Kraftaufnahmequantität Nachteile mit sich brachten. Grundsätzlich sind solche Verbindungen zum Beispiel aus der DE 100 17 335 A1 bekannt, in der ein Gehäuse mit einem Steckkontakt mit einer Schnapp-Rastverbindung verbunden ist. Die Leiterplatte muss auch hier separat gelagert werden.

Es ist Aufgabe der vorliegenden Erfindung, die Nachteile die voranstehend erläutert worden sind, zumindest teilweise zu beheben. Insbesondere ist es Aufgabe der vorliegenden Erfindung, ein Elektronikmodul sowie ein Verfahren für die Montage eines Elektronikmoduls zur Verfügung zu stellen, bei welchem in besonders einfacher und kostengünstiger Weise die Lagerung der Leiterplatte im Inneren des Gehäuses möglich wird, und gleichzeitig auch höhere Kräfte, wie zum Beispiel Steckkräfte bei Lösen und Verbinden eines Steckkontaktes, abstützbar sind.

Voranstehende Aufgabe wird gelöst durch ein Elektronikmodul mit den Merkmalen des Anspruchs 1 sowie durch ein Verfahren mit den Merkmalen des Anspruchs 9. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Elektronikmodul beschrieben sind, selbstverständlich auch im Zusammenhang mit dem erfindungsgemäßen Verfahren und jeweils umgekehrt, so dass bezüglich der Offenbarung zu den einzelnen Erfindungsaspekten stets wechselseitig Bezug genommen wird bzw. werden kann.

Ein erfindungsgemäßes Elektronikmodul weist wenigstens eine Leiterplatte und ein die wenigstens eine Leiterplatte umgebendes Gehäuse mit zumindest einem Oberteil und mindestens einem Unterteil auf. Mit anderen Worten wird das Gehäuse insbesondere durch das eine Oberteil und das eine Unterteil ausgebildet. Dabei können zusätzliche Mittel vorhanden sein, welche zum Beispiel in Form von Schnapp-Rastverbindungen die beiden Teile des Gehäuses miteinander zu einem Gesamtgehäuse verbinden. Die Zweiteiligkeit des Gehäuses ermöglicht das Anordnen der Leiterplatte in einfacher und kostengünstiger Weise im Inneren dieses Gehäuses.

Ein erfindungsgemäßes Elektronikmodul zeichnet sich dadurch aus, dass das Gehäuse wenigstens eine Rastvorrichtung für die Leiterplatte aufweist, um Kraft von der Leiterplatte auf das Gehäuse zu übertragen. Darüber hinaus ist die Leiterplatte mit zumindest einer Öffnung für die Interaktion mit der wenigstens einen Rastvorrichtung versehen. Im Gegensatz zu den aufwendigen Schmelz- und Schraubverbindungen bekannter Elektronikmodule ist hier eine einfache Rastverbindung vorgesehen. Diese Rastverbindung bringt jedoch eine zusätzliche Stabilität mit sich, so dass entgegen einem einfachen Einlegen im Inneren des Gehäuses die gewünschte höhere Kraftübertragung über die Rastvorrichtung auf das Gehäuse möglich wird. Damit kann ein erfindungsgemäßes Elektronikmodul insbesondere für Leiterplatten zum Einsatz kommen, bei welchem die Leiterplatte selbst direkt mit einer Steckverbindung ausgestattet ist. Damit wird es möglich, die Leiterplatte kompakter zu gestalten und insbesondere auf Zusatzleitungen zu einer separaten Steckverbindung zu verzichten. Dies führt zu kleineren Elektronikmodulen, insbesondere zu kompakteren Gehäuseformen.

Eine Rastvorrichtung im Rahmen der vorliegenden Erfindung kann ein- oder mehrteilig sein. Insbesondere weist die Rastvorrichtung wenigstens zwei Bauteile auf, die miteinander zusammenwirken um die Rastwirkung zu erzielen. Die Rastvorrichtung ist dabei vorzugsweise Teil des Gehäuses und kann einteilig, integral oder materialschlüssig mit dem jeweiligen Gehäuseteil ausgebildet sein. Vorzugsweise sind die einzelnen Bauteile der Rastvorrichtung an unterschiedlichen Bauteilen des Gehäuses angeordnet.

Ein erfindungsgemäßes Elektronikmodul wird am einfachsten derart montiert, dass zumindest ein Teil der Rastvorrichtung mit den Öffnungen der Leiterplatte in Interaktion tritt, also insbesondere zumindest teilweise einrastet. In einem anschließenden, zweiten Schritt wird das Gehäuse geschlossen, also Oberteil und Unterteil miteinander verbunden, und damit die Leiterplatte sozusagen im Gehäuse eingehaust. Durch das vorrangige Verbinden mit Hilfe einer Rastvorrichtung, die zumindest eine Teilverrastung durchführt, ist eine einfache Festlegung der Leiterplatte an der gewünschten und vordefinierten Position möglich. Danach wird ausschließlich das Oberteil mit dem Unterteil verbunden, um das Gehäuse zu schließen, ohne dass zusätzliches Augenmerk auf die Positionierung der Leiterplatte notwendig ist. Eine finale Verrastung muss dabei zumindest zum Zeitpunkt nach dem Schließen des Oberteils und des Unterteils, also bei geschlossenem Gehäuse vorliegen. Damit kann die Rastvorrichtung also eine Erstverrastung und eine finale Verrastung aufweisen, die sich voneinander unterscheiden, und insbesondere erst im geschlossenen Zustand des Gehäuses die finale Verrastung zur Verfügung stellen.

Damit wird durch ein erfindungsgemäßes Elektronikmodul eine besonders einfache Montage des Elektronikmoduls und darüber hinaus eine kompaktere Ausgestaltung des Moduls, insbesondere des Gehäuses möglich.

Es kann von Vorteil sein, wenn bei einem erfindungsgemäßen Elektronikmodul die wenigstens eine Rastvorrichtung eine Rastnase und einen Steg aufweist, die vorzugsweise an unterschiedlichen Teilen des Gehäuses angeordnet sind. Dadurch wird sozusagen ein Zusammenstecken der Rastvorrichtung möglich. Mit anderen Worten treten die einzelnen Bauteile der Rastvorrichtung erst beim Verbinden des Oberteils mit dem Unterteil des Gehäuses miteinander in Kontakt. Dabei können die beiden Bauteile, also Rastnase und Steg, unterschiedliche Funktionen aufweisen. Vorzugsweise dient die Rastnase dazu bereits eine Vorfixierung der Leiterplatte an dem Oberteil und/oder dem Unterteil zu gewährleisten. Damit kann die Rastnase eine Rastfläche aufweisen, die eine Ersteinrastung durch die Öffnung der Leiterplatte zur Verfügung stellt. Der Steg kann dazu dienen die Sicherungsfunktion für die Rastnase zu übernehmen. So wird ein Steg vorgesehen, der vorzugsweise ebenfalls durch die Öffnungen der Leiterplatte ragt und damit eine Bewegung der Rastnase aus der verrasteten Position heraus unmöglich macht. Dies führt dazu, dass zum Einen aufgrund des Fehlens des Steges bei der Montage der Leiterplatte an der Rastnase eine besonders einfache Verrastung möglich ist, während durch das Schließen des Gehäuses, also durch das Aufsetzen des Oberteils auf das Unterteil, automatisch die Sicherung der Rastnase in der Verrastposition durch den Steg erfolgt. Damit wird die Montage noch weiter erleichtert ohne die Sicherheit im montierten Zustand für die Positionierung der Leiterplatte zu reduzieren. Darüber hinaus wird durch eine derartige Ausgestaltung eine Festlegung in einer ebenen Richtung vermieden. Vielmehr wird damit eine freie Bewegbarkeit der Leiterplatte zumindest in gewissen Grenzen möglich, so dass ein Verspannen innerhalb des Gehäuses vermieden wird. Solche Verspannungen könnten ansonsten zur Beeinträchtigung und im schlimmsten Fall zu einer Beschädigung oder Zerstörung der Leiterplatte oder Leiterbahnen auf der Leiterplatte führen. Damit wird also eine Rastfläche zur Verfügung gestellt, welche die notwendigen Kräfte in dieser notwendigen Kraftrichtung, also zum Beispiel in der Steckrichtung eines Steckkontaktes, abfedert bzw. abträgt. In den weiteren Kraftrichtungen, also zum Beispiel entlang der Ebene der Leiterplatte, bleibt eine im Wesentlichen frei bewegliche Ausführungsform der Leiterplatte vorhanden, so dass hier ein kleines Spiel zur Verfügung steht, um Temperaturspannungen oder Gehäusespannungen auszugleichen.

Es kann weiter von Vorteil sein, wenn bei einem erfindungsgemäßen Elektronikmodul der Steg und die Rastnase einer Rastvorrichtung beide jeweils durch die gleiche Öffnung in der Leiterplatte ragen. Diese Situation wird erzielt bei bzw. nach dem Schließen des Oberteils und des Unterteils des Gehäuses. Damit sind keine zusätzlichen Öffnungen für die Stege nötig und die Rastvorrichtung komplettiert sich automatisch selbst beim Schließen des Gehäuses. Hierfür ist es vorteilhaft, wenn der Steg und die Rastnase zueinander derart korrelieren, dass sie aufgrund ihrer Positionierung am entsprechenden Bauteil automatisch in die gewünschte Korrelation gelangen, wenn das Gehäuse geschlossen wird. Damit korrelieren vorzugsweise die Positionen der einzelnen Bauteile der Rastvorrichtung mit der entsprechenden Positionierhilfe bei Verschlusselementen für das Gehäuse. Beispielsweise kann das Gehäuse eine umlaufende Nut an einem der beiden Bauteile und eine entsprechend umlaufende nasenartige Fortsetzung an dem anderen Bauteil aufweisen, die nicht nur eine Rastfunktion, sondern darüber hinaus eine Positionier- bzw. Führungsposition mit sich bringen. Der Steg kann im Rahmen der vorliegenden Erfindung auch als Sicherungsmittel für die Rastvorrichtung bezeichnet werden. Vorzugsweise ist der Steg dabei nur mit geringer Flexibilität oder keiner Flexibilität ausgestattet, sondern ausschließlich die Rastnase. Damit kann die Rastvorrichtung in zwei Funktionsschritte unterteilt werden. Die Rastnase ist frei bzw. in gewünschten Grenzen flexibel, so dass sie durch die Öffnungen in der Leiterplatte hindurch einrasten bzw. einschnappen kann. Sobald jedoch das Gehäuse geschlossen wird, indem Oberteil und Unterteil aufeinandergesetzt werden, wird der Steg durch dieselbe Öffnung der Rastnase hindurchgeführt. In dieser hindurchgeführten Position wird durch den Steg die Bewegbarkeit der Rastnase eingeschränkt, also insbesondere die Flexibilität der Rastnase unterbunden. Trotz der materialtechnisch gegebenen Flexibilität der Rastnase blockiert also der Steg die Bewegbarkeit der Rastnase selbst. Um den Steg selbst möglichst unflexibel zu gestalten, kann dieser eine entsprechende Materialausbildung aufweisen und/oder zusätzlich geometrische Abstützvorrichtungen mit sich bringen. So können zum Beispiel zusätzliche Rippen vorgesehen sein; um insbesondere in der Sicherungsrichtung eine Abstützung des Steges zu ermöglichen.

Es kann von Vorteil sein, wenn bei einem erfindungsgemäßen Elektronikmodul die Rastnase zumindest eine gekrümmte Oberfläche aufweist, welche beim Verrasten mit einem Rand der Öffnung in der Leiterplatte in Berührung kommt. Diese Rastnase kann durch die gekrümmte Oberfläche eine noch leichtere Verrastung zum Beispiel eine Erstverrastung durchführen. Durch die gekrümmte Oberfläche wird insbesondere eine Art Häkelnadelform erzielt, wodurch ein besonderes leichtes Einführen der Rastnase in die Öffnung der Leiterplatte ermöglicht wird. So kann auch von einer domartigen oder spitzen Fortsetzung der Rastnase gesprochen werden. Insbesondere ist dabei die gekrümmte Oberfläche in einer Art Viertelkreis mit relativ kleinem Radius gekrümmt. Vorzugsweise sind darüber hinaus zwei oder mehr gekrümmte Oberflächen vorgesehen, um insgesamt eine domartige bzw. häkelnadelspitzenartige Form zur Verfügung zu stellen. Die Rastnase ist vorzugsweise zweiteilig ausgebildet, so dass die Spitze, also der Bereich der gekrümmten Oberfläche, unflexibel und dahinter ein flexibler Bereich vorgesehen ist. Vorzugsweise handelt es sich zumindest bei der Rastnase und/oder bei dem Steg um ein Bauteil, welches integral, zum Beispiel durch ein Spritzgussverfahren, mit dem jeweiligen Bauteil des Gehäuses, also dem Oberteil und/oder dem Unterteil ausgebildet ist. Die Rastnase ist also vorzugsweise hinsichtlich der Funktion zweiteilig mit einem Hals und einer Spitze ausgestattet.

Es kann weiter vorteilhaft sein, wenn bei einem erfindungsgemäßen Elektronikmodul die Rastnase zumindest eine Rastfläche aufweist, die im Wesentlichen eben ist, insbesondere im Wesentlichen parallel zu der Oberfläche der Leiterplatte. Diese Rastfläche dient als Auflagefläche für die Leiterplatte. Die im Wesentlichen vorgesehene Parallelität zur Oberfläche der Leiterplatte dient dazu, die entsprechende Kraftabtragung bei der Lagerung der Leiterplatte zur Verfügung zu stellen. Dementsprechend ist die Stützrichtung der Rastfläche, also die Richtung der Abtragung von Kräften insbesondere derart ausgerichtet, dass sie die Steckkräfte bei vorgesehenem Steckkontakt auf der Leiterplatte abtragen kann. Dabei ist vorzugsweise von Steckkontakten auszugehen, wobei die Steckkräfte senkrecht zur Leiterplatte und dementsprechend auch senkrecht zur vorgesehenen Rastfläche aufgebracht werden. Insbesondere wird eine solche Rastnase mit einer entsprechend gekrümmten Oberfläche der Ausführungsform gemäß dem voranstehenden Absatz ausgeführt sein.

Es kann weiter vorteilhaft sein, wenn bei einem erfindungsgemäßen Elektronikmodul der Steg zumindest abschnittsweise eine keilartige Form aufweist, um ein erleichtertes Einführen in die Öffnung der Leiterplatte zu ermöglichen. Aufgrund der Tatsache, dass der Steg vorzugsweise erst beim Schließen des Gehäuses in die Öffnung der Leiterplatte eingeführt wird, wird durch die keilartige Form das Einführen erleichtert, da zu diesem Zeitpunkt die Position des Steges wie auch der Öffnung in der Leiterplatte von außen nicht mehr sichtbar ist. Das bedeutet auch, dass der Steg vorzugsweise länger ist als für die Sicherungsfunktion notwendig, so dass ein Einfädeln noch in der sichtbaren Position der beiden Teile des Gehäuses zueinander möglich ist. Anschließend verbreitert sich der Steg, um keilartig die Sicherungsfunktion zu erfüllen und insbesondere die Rastnase in der verrasteten Position zu halten. Darüber hinaus wird durch das Führen ein unerwünschtes Verkippen vermieden. Auch kann damit die Rastvorrichtung, also die Korrelation zwischen Rastnase und Steg auch für die entsprechende Ausrichtung und Positionierung der beiden Gehäuseteile zueinander Verwendung finden. Darüber hinaus ist der Steg vorzugsweise derart ausgebildet, dass er vorzugsweise keine Auflagefläche in Kraftabstützungsrichtung für die Leiterplatte mit sich bringt. Vorzugsweise ist also nur eine Sicherungsfunktion zur Verfügung gestellt und kein Kontakt in Kraftübertragungsrichtung zwischen der Leiterplatte und dem Steg vorgesehen.

Es ist möglich, dass in vorteilhafter Weise bei einem erfindungsgemäßen Elektronikmodul die Rastnase von einem Ort der Krafteinleitung, insbesondere dem Ort einer Steckverbindung auf einer Leiterplatte weg gerichtet ist. Dies verbessert die Abtragung der Steckkräfte weiter. Insbesondere wird dabei ein unerwünschtes Verrutschen der Rastnase bzw. der Leiterplatte relativ zueinander verhindert. Werden mehrere Rastvorrichtungen vorgesehen, so sind diese insbesondere um den Ort der Krafteinleitung herum verteilt. Dadurch ergibt sich auch eine Ausrichtung der Rastnase der einzelnen Rastverbindungen in unterschiedlicher Richtung, was die Stabilität des gesamten Konzeptes des Elektronikmoduls noch weiter verbessert.

Ebenfalls vorteilhaft kann es sein, wenn bei einem erfindungsgemäßen Elektronikmodul zumindest zwei Rastvorrichtungen vorgesehen sind, deren Rastrichtungen sich voneinander unterscheiden. Wie bereits im voranstehenden Absatz beschrieben, wird eine unterschiedliche Rastrichtung für zumindest zwei Rastvorrichtungen zu einer höheren Stabilität eines Elektronikmoduls führen. Insbesondere die Lagerung der Leiterplatten wird auf diese Weise deutlich stabiler. Die Rastvorrichtung, insbesondere die jeweilige Rastnase kann also eine Rastrichtung und eine Freigaberichtung aufweisen, die im Wesentlichen konträr zueinander ausgerichtet sind. Vorzugsweise stehen auch die Kraftübertragungsrichtung für eine Steckverbindung und die Rastrichtung und Freigaberichtung jeweils senkrecht aufeinander, um ein versehentliches Freigeben bzw. Entrasten so unwahrscheinlich wie möglich zu machen. Damit wird ein unbewusstes und unerwünschtes Herunterrutschen auch dann vermieden bzw. verhindert, wenn kein Steg für die Sicherung der Rastnase zur Verfügung gestellt wird.

Ebenfalls Gegenstand der vorliegenden Erfindung ist ein Verfahren für die Montage eines Elektromoduls aufweisend wenigstens eine Leiterplatte und ein die wenigstens eine Leiterplatte umgebendes Gehäuse mit zumindest einem Oberteil und mindestens einem Unterteil und wenigstens einer Rastvorrichtung aufweisend die folgenden Schritte:
- Verrasten der Leiterplatte an der Rastvorrichtung,
- Schließen des Gehäuses.

Ein erfindungsgemäßes Verfahren wird insbesondere für ein erfindungsgemäßes Elektronikmodul durchgeführt. Dementsprechend bringt ein erfindungsgemäßes Verfahren die gleichen Vorteile mit sich, wie sie ausführlich mit Bezug auf ein erfindungsgemäßes Elektronikmodul erläutert worden sind.

Die vorliegende Erfindung wird näher erläutert anhand der beigefügten Zeichnungsfiguren. Die dabei verwendeten Begrifflichkeiten "links", "rechts", "oben" und "unten" beziehen sich auf eine Ausrichtung der Zeichnungsfiguren mit normal lesbaren Bezugszeichen. Es zeigen schematisch:
- Figur 1: eine Ausführungsform eines erfindungsgemäßen Elektronikmoduls vor der Montage,
- Figur 2: die Ausführungsform gemäß Fig. 1 nach der Montage,
- Figur 3a: eine weitere Ausführungsform eines erfindungsgemäßen Elektronikmoduls vor der Montage, und
- Figur 3b: die Ausführungsform der Fig. 3a nach der Montage.

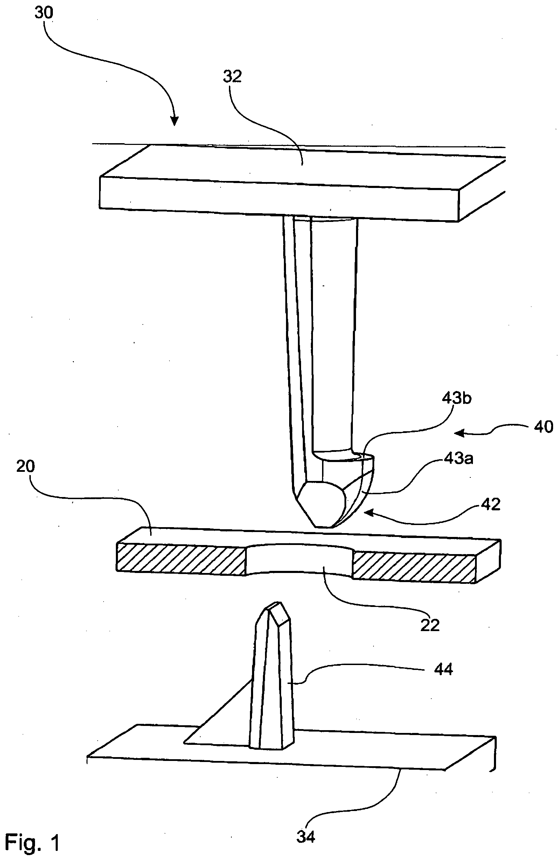

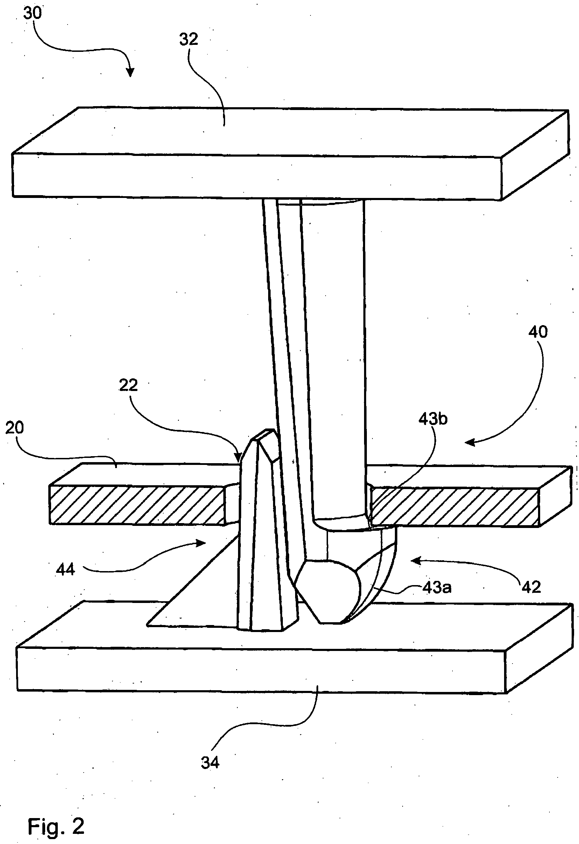

In den Fig. 1 und 2 ist eine erste Ausführungsform eines erfindungsgemäßen Elektronikmoduls 10 dargestellt. Dieses weist ein Gehäuse 30 mit einem Oberteil 32 und einem Unterteil 34 auf. Am Oberteil 32 ist ein Teil einer Rastvorrichtung 40, nämlich die Rastnase 42 angeordnet. An dem Unterteil 34 ist ein Steg 44 der Rastvorrichtung 40 angeordnet. Die Anordnung ist in beiden Fällen eine integrale Ausführungsform durch ein Spritzgussverfahren. Der Steg 44 ist über eine Rippe in einer Richtung abgestützt, um die Flexibilität in dieser Freigaberichtung der Rastnase 42 abzusichern. Die Rastnase 42 ist über einen Hals mit dem Oberteil 32 des Gehäuses 30 verbunden.

Die Rastnase 42 dieser Ausführungsform weist zwei unterschiedliche Flächen auf, nämlich eine gekrümmte Fläche 43a und eine Rastfläche 43b. Die gekrümmte Fläche 43a ist hier eine vorzugsweise doppelt gekrümmte Fläche, so dass sich insgesamt eine häkelnadelartige Form für die Rastnase 42 ergibt.

Die Funktion der voranstehend beschriebenen Flächen und Elemente ergibt sich insbesondere aus der Korrelation der Fig. 1 und 2. Um eine Montage des Elektronikmoduls 10 dieser Ausführungsform zu erzielen, wird in einem ersten Schritt die Leiterplatte 20 mit der Rastnase 42 der Rastvorrichtung 40 verrastet. Hierfür ist in der Leiterplatte 20 zumindest eine Öffnung 22 für jede Rastvorrichtung 40 vorgesehen. Durch diese Öffnung 22 wird die Rastnase 42 geführt, so dass ein erleichtertes Einfädeln der Rastnase 42 durch die gekrümmte Oberfläche 43a möglich ist. Sobald die gekrümmte Oberfläche 43a den Rand der Öffnung 22 der Leiterplatte 20 verlassen hat, rastet die Rastnase 42 ein und die Leiterplatte 20 kommt mit der Unterseite in Kontakt mit der Rastfläche 43b. Damit erfolgt ein Abstützen der Leiterplatte 20 gegen die Rastnasen 42 und eine Kraftübertragung zwischen der Leiterplatte 20 und der Rastfläche 43b. Mit anderen Worten ist in dieser Position die Leiterplatte 20 bereits relativ zum Oberteil 32 des Gehäuses 30 festgelegt.

Im nächsten Schritt wird eine Verbindung des Gehäuses 30, also insbesondere des Oberteils 32 und des Unterteils 34 erfolgen. Die beiden Teile 32 und 34 werden aufeinander zu bewegt, wobei sich der keilartig geformte Steg 44 ebenfalls durch die gleiche Öffnung 22 in der Leiterplatte 20 bewegt. Dabei wird durch den Steg 44 keine oder nur eine leichte Bewegung der Rastnase 42 in Fig. 2 nach rechts erfolgen. Jedoch sichert der Steg 44 ab, dass sich die Rastnase 42 nach dem Zusammenfügen des Oberteils 32 mit dem Unterteil 34 nicht mehr nach links, also nicht mehr in Freigaberichtung, bewegen kann. Der Steg 44 sichert die Rastnase 42 in Freigaberichtung ab. Die Rippe zur Versteifung des Steges 44 sichert darüber hinaus ab, dass die Flexibilität gerade in dieser Freigaberichtung des Steges 44 noch weiter reduziert ist. Die Abtragung der Lagerkräfte erfolgt nur über die Rastfläche 43b, so dass die Leiterplatte 20 sozusagen schwebend auf der Rastfläche 43b aufgehängt ist. Dies lässt noch Spiel in Richtung der Ebene der Leiterplatte 20 zu, so dass ein Verspannen der Leiterplatte 20 in diesen ebenen Richtungen vermieden wird.

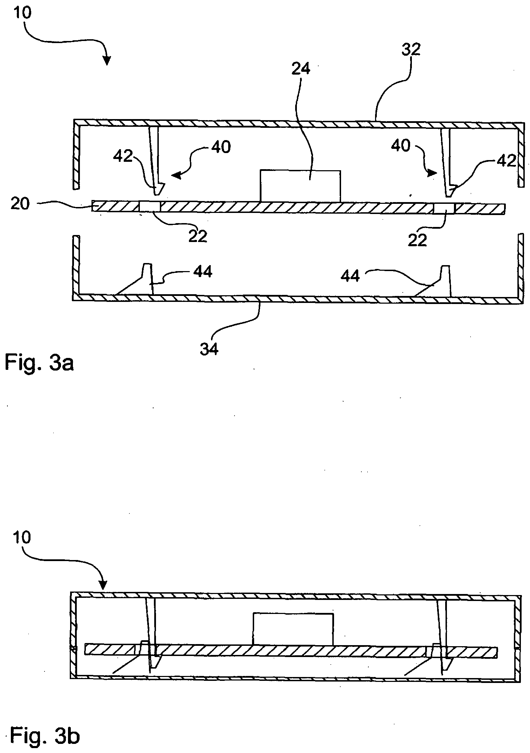

Die Fig. 3a und 3b zeigen eine Variante des Elektronikmoduls 10, wobei hier im Schnitt zwei Rastvorrichtungen 40 vorgesehen sind, die ähnlich oder gleich gemäß Fig. 1 oder 2 ausgebildet sind. Hier ist gut zu erkennen, dass zwischen diesen beiden Rastvorrichtungen 40 ein Steckkontakt 24 angeordnet ist. Dieser Steckkontakt 24 ist insbesondere auch von außerhalb des Gehäuses 30 zugänglich, so dass Einstecken von oben auf die Leiterplatte 20 erfolgt. In Fig. 3a ist der Vormontagezustand dargestellt, wobei in einem ersten Schritt die Leiterplatte 20 über die Öffnung 22 mit der Rastnase 42 verrastet wird und in einem zweiten Schritt das Oberteil 32 mit dem Unterteil 34 zum Gehäuse 30 verbunden wird. Im Ergebnis sieht das Elektronikmodul 10 schematisch wie in Fig. 3b dargestellt aus. Wird nun eine Steckverbindung mit dem Steckkontakt 24 gewünscht, so wird von oben auf diesen Steckkontakt 24 ein Gegenstecker aufgesteckt, so dass die Steckkräfte über Rastflächen 43b der Rastnasen 42 über das Gehäuse 30 aufgefangen werden können.

Die voranstehend beschriebenen Ausführungsformen diskutieren die vorliegende Erfindung nur im Rahmen von Beispielen. Selbstverständlich können einzelne Details und Merkmale der beschriebenen Ausführungsformen, sofern technisch sinnvoll, frei miteinander kombiniert werden, ohne den Rahmen der vorliegenden Erfindung zu verlassen.

### Bezugszeichenliste

- 10: Elektronikmodul
- 20: Leiterplatte
- 22: Öffnung
- 24: Steckkontakt
- 30: Gehäuse
- 32: Oberteil
- 34: Unterteil
- 40: Rastvorrichtung
- 42: Rastnase
- 43a: Gekrümmte Oberfläche
- 43b: Rastfläche
- 44: Steg

## Patentansprüche

1. Elektronikmodul (10), aufweisend wenigstens eine Leiterplatte (20) und ein die wenigstens eine Leiterplatte (20) umgebendes Gehäuse (30) mit zumindest einem Oberteil (32) und mindestens einem Unterteil (34), wobei das Gehäuse (30) wenigstens eine Rastvorrichtung (40) für die Leiterplatte (20) aufweist, um Kraft von der Leiterplatte (20) auf das Gehäuse (30) zu übertragen, und die Leiterplatte (20) zumindest eine Öffnung (22) für die Interaktion mit der wenigstens einen Rastvorrichtung (40) aufweist, und wobei die wenigstens eine Rastvorrichtung (40) eine Rastnase (42) und einen Steg (44) aufweist, die an unterschiedlichen Teilen (32, 34) des Gehäuses (30) angeordnet sind, **dadurch gekennzeichnet, dass** die Rastnase (42) zumindest eine Rastfläche (43b) aufweist, die im Wesentlichen eben ist und im Wesentlichen parallel zu der Oberfläche der Leiterplatte (20) und dass die Rastnasse (42) von einem Ort der Krafteinleitung, dem Ort einer Steckverbindung, auf der Leiterplatte (20) weggerichtet ist, wobei ein direkt als Teil der Leiterplatte (2) ausgebildete Steckkontakt (24) von außerhalb des Gehäuses (30) zugänglich ist, so dass Einstecken von oben auf die Leiterplatte (20) erfolgt und die Unterseite der Leiterplatte (2) mit der Rastfläche (43b) in Kontakt kommt.

2. Elektronikmodul (10) nach Anspruch 1, **dadurch gekennzeichnet, dass** der Steg (44) und die Rastnase (42) einer Rastvorrichtung (40) beide jeweils durch die gleiche Öffnung (22) in der Leiterplatte (20) ragen.

3. Elektronikmodul (10) nach einem der Ansprüche 1 oder 2, **dadurch gekennzeichnet, dass** die Rastnase (42) zumindest eine gekrümmte Oberfläche (43a) aufweist, welche beim Verrasten mit einem Rand der Öffnung (22) in der Leiterplatte (20) in Berührung kommt.

4. Elektronikmodul (10) nach einem der Ansprüche 1 bis 3, **dadurch gekennzeichnet, dass** der Steg (44) zumindest abschnittsweise eine keilartige Form aufweist, um ein erleichtertes Einführen in die Öffnung (22) der Leiterplatte (20) zu ermöglichen.

5. Elektronikmodul (10) nach einem der vorangegangenen Ansprüche, **dadurch gekennzeichnet, dass** zumindest zwei Rastvorrichtungen (40) vorgesehen sind, deren Rastrichtungen sich voneinander unterscheiden.

6. Verfahren für die Montage eines Elektronikmoduls (10), aufweisend wenigstens eine Leiterplatte (20) und ein die wenigstens eine Leiterplatte (20) umgebendes Gehäuse (30) mit zumindest einem Oberteil (32) und mindestens einem Unterteil (34) und wenigstens einer Rastvorrichtung (40), aufweisend die folgenden Schritte:
• Verrasten der Leiterplatte (20) an der Rastvorrichtung (40),
• Schließen des Gehäuses (30),
**dadurch gekennzeichnet, dass** das Verfahren für ein Elektronikmodul (10) mit den Merkmalen eines der Ansprüche 1 bis 5 durchgeführt wird.

## Claims

1. Electronic module (10), having at least one printed circuit board (20) and one housing (30) with at least one upper part (32) and at least one lower part (34) enclosing the at least one printed circuit board (20), wherein the housing (30) has at least one snap-fastening mechanism (40) for the printed circuit board (20) to transfer force from the printed circuit board (20) onto the housing (30), and the printed circuit board (20) has at least one opening (22) for the interaction with the at least one snap-fastening mechanism (40), and wherein the at least one snap-fastening mechanism (40) has a detent hook (42) and a web (44) being arranged on different parts (32, 34) of the housing (30), **characterized in that** the detent hook (42) has at least one detent surface (43b), which is essentially plane and essentially parallel relative to the surface of the printed circuit board (20) and **in that** the detent hook (42) points away from a place where force is applied, the place of a plug and socket connection on the printed circuit board (20), a plug-in contact (24) being integrally formed as part of the printed circuit board (2) being accessible from outside the housing (30), so that plugging-in is executed from above onto the printed circuit board (20) and the rear side of the printed circuit board (2) comes into contact with the detent surface (43b).

2. Electronic module (10) according to Claim 1, **characterized in that** the web (44) and the detent hook (42) of a snap-fastening mechanism (40) both protrude through the same opening (22) in the printed circuit board (20).

3. Electronic module (10) according to one of the Claims 1 or 2, **characterized in that** the detent hook (42) has at least one curved surface (43a) which comes into contact with an edge of the opening (22) in the printed circuit board (20).

4. Electronic module (10) according to one of the Claims 1 to 3, **characterized in that** the web (44) has a wedge-shaped shape at least in sections to simplify the insertion in the opening (22) of the printed circuit board (22).

5. Electronic module (10) according to one of the above Claims, **characterized in that** at least two snap-fastening mechanisms (40) are planned whose direction of snap-fastening differ from one another.

6. Procedure for the assembly of an electronic module (10), having at least one printed circuit board (20)and a housing (30) enclosing at least one printed circuit board (20), having at least one upper part (32) and at least one lower part (34) and at least one snap-fastening mechanism (40), comprising the following steps:
- snap-fastening of the printed circuit board (20) on the snap-fastening mechanism (40),
- closing of the housing (30)
**characterized in that** the procedure for an electronic module (10) with the characteristics of one of the Claims 1 to 5 is executed.

## Revendications

1. Module électronique (10) présentant au moins un circuit imprimé (20) et un boîtier (30) entourant ledit au moins un circuit imprimé (20) avec au moins une partie supérieure (32) et au moins une partie inférieure (34), le boîtier (30) présentant au moins un dispositif d'encliquetage (40) pour le circuit imprime (20) pour transmettre la force du circuit imprimé (20) au boîtier (30) et le circuit imprimé (20) présentant au moins une ouverture (22) pour l'interaction avec ledit au moins un dispositif d'encliquetage (40) et ledit au moins un dispositif d'encliquetage (40) présentant un ergot d'encliquetage (42) et une traverse (44) étant disposés sur des parties différentes (32, 34) du boîtier (30),
**caractérisé en ce que**
l'ergot d'encliquetage (42) présente au moins une surface d'encliquetage (43b) qui est essentiellement plane et essentiellement parallèle à la surface du circuit imprimé (20) et que l'ergot d'encliquetage (42) est orienté opposé à un endroit de l'introduction de force, l'endroit d'une connexion enfichable, sur le circuit imprimé (20), un contact à fiches (24) réalisé directement en tant que partie du circuit imprimé (20) étant accessible de l'extérieur du boîtier (30) de manière à ce que l'insertion sur le circuit imprimé (20) s'effectue de dessus et la partie inférieure du circuit imprimé (20) sera en contact avec la surface d'encliquetage (43b).

2. Module électronique (10) selon la revendication 1,
**caractérisé en ce que** la traverse (44) et l'ergot d'encliquetage (42) d'un dispositif d'encliquetage (40) émergent chaque fois tous les deux de la même ouverture (22) du circuit imprimé (20).

3. Module électronique (10) selon l'une des revendications 1 ou 2,
**caractérisé en ce que** l'ergot d'encliquetage (42) présente au moins une surface courbée (43a) qui lors de l'encliquetage entre en contact avec un bord de l'ouverture (22) au circuit imprimé (20).

4. Module électronique (10) selon l'une des revendications 1 à 3,
**caractérisé en ce que** la traverse (44) présente au moins par sections une forme de coin pour permettre une introduction facilitée dans l'ouverture (22) du circuit imprimé (20).

5. Module électronique (10) selon l'une des revendications précédentes, **caractérisé en ce qu**'au moins deux dispositifs d'encliquetage (40) sont prévus dont les directions d'encliquetage diffèrent l'une de l'autre.

6. Procédé pour le montage d'un module électronique (10) présentant au moins un circuit imprimé (20) et un boîtier (30) entourant ledit au moins un circuit imprimé (20) avec au moins une partie supérieure (32) et au moins une partie inférieure (34) et au moins un dispositif d'encliquetage (40),
présentant les étapes suivantes :
• encliquetage du circuit imprimé (20) sur le dispositif d'encliquetage (40),
• fermeture du boîtier (30),
**caractérisé en ce que** le procédé pour un module électronique (10) sera réalisé selon les caractéristiques d'une des revendications 1 à 5.
